# EUROPÄISCHE PATENTSCHRIFT

(11) **EP 3 744 159 B1**
(45) Veröffentlichungstag und Bekanntmachung des Hinweises auf die Patenterteilung: **06.03.2024**
(21) Anmeldenummer: 19702083.7
(22) Anmeldetag: 28.01.2019
(51) Int. Cl.: H05K 7/20, H05K 7/14

(54) **STECKVERBINDER UND ELEKTRONISCHES GERÄT**
ELECTRICAL CONNECTOR AND ELECTRONIC DEVICE
CONNECTEUR ENFICHABLE ET DISPOSITIF ÉLECTRONIQUE

(30) Priorität: 26.01.2018 DE 102018101779
(43) Veröffentlichungstag der Anmeldung: 02.12.2020
(73) Patentinhaber: PHOENIX CONTACT GmbH & Co. KG, 32825 Blomberg (DE)
(72) Erfinder: ENGEL, Andreas, 32816 Schieder-Schwalenberg (DE); MOSLER, Michael, 31812 Bad Pyrmont (DE); WITTE, Sebastian, 31789 Hameln (DE)
(74) Vertreter: Richly & Ritschel Patentanwälte PartG mbB
(86) Internationale Anmeldenummer: PCT/EP2019/051984
(87) Internationale Veröffentlichungsnummer: WO 2019/145530

(56) Entgegenhaltungen:
- DE-U1-202015 104 404
- US-A1- 2002 094 772
- US-A1- 2007 253 163
- US-B1- 8 068 340

## Beschreibung

Die vorliegende Erfindung betrifft einen Steckverbinder und ein elektronisches Gerät mit einem solchen Steckverbinder.

Bei der Entwicklung von Gehäusen für elektronische Geräte wird eine Standardisierung der Gehäuse angestrebt, um ein bestehendes Gehäuse für eine Vielzahl verschiedener Geräte einsetzen zu können.

Um einen zuverlässigen Betrieb elektronischer Geräte zu gewährleisten, ist häufig eine aktive Kühlung durch Lüfter erforderlich.

Hierbei ist es bekannt, einen Lüfter fest in die Struktur eines Gerätegehäuses zu integrieren. Dies hat den Vorteil, dass ein solcher interner Lüfter kompakt innerhalb des Bauraums des Gerätegehäuses aufgenommen ist. Nachteilig ist jedoch, dass der Lüfter im Falle eines Defekts üblicherweise nur mit großem Aufwand getauscht oder repariert werden kann. So kann es dazu kommen, dass die Lebensdauer des Lüfters die Lebensdauer des elektronischen Geräts insgesamt begrenzt, da ein Austausch eines defekten Lüfters nicht rentabel ist.

Weiter ist es bekannt, Lüfter nachträglich an einem Gerätegehäuse eines elektronischen Gerätes zu montieren. Hierzu kann ein Lüfter an einer Außenseite eine Gehäusewandung angeschraubt oder geklemmt werden und extern über Kabelklemmen verdrahtet werden. Hierbei ist nachteilig, dass derartige Nachrüstlösungen oftmals für den Endkunden als "Provisorium" erscheinen und durch die außenliegenden Bauteile zudem leicht beschädigt werden können.

Vor diesem Hintergrund liegt der Erfindung die technische Problemstellung zugrunde eine verbesserte konstruktive Einbindung eines Lüfters in ein elektronisches Gerät zu ermöglichen, wobei ein Lüfter insbesondere nachrüstbar, austauschbar und kompakt in einem elektronischen Gerät integriert bzw. an einem elektronischen Gerät befestigt werden kann.

Die US 8,068,340 B1 beschreibt eine reversible Gebläseablagevorrichtung für eine Stromversorgungseinheit. Die US 2002/094772 A1 beschreibt einen Ventilatorträger für eine oder mehrere Ventilatoreinheiten. Die US 2007/0253163 beschreibt ein Kühlsystem aufweisend einen oder mehrere Ventilatoren in einem Gehäuse. Die DE 20 2015 104 404 U1 beschreibt eine Wärmeableitungsvorrichtung mit Aufladefunktion.

Die voranstehende beschriebene technische Problemstellung wird jeweils gelöst durch einen Steckverbinder nach Anspruch 1 und ein elektronisches Gerät nach Anspruch 6. Weitere Ausgestaltungen der Erfindung ergeben sich aus den abhängigen Ansprüchen und der nachstehenden Beschreibung.

Gemäß einem ersten Aspekt betrifft die Erfindung einen Steckverbinder, mit einem Steckverbindergehäuse, das einen Eingang zum Anschluss einer Versorgungsspannung und einen Ausgang zum Weiterleiten der Versorgungsspannung an einen Verbraucher eines elektronischen Gerätes hat, wobei das Steckverbindergehäuse in einen Spannungsversorgungssteckplatz eines Gerätegehäuses des elektronischen Geräts einsteckbar ist, um einen Spannungsversorgungsanschluss des elektronischen Geräts bereitzustellen, und wobei das Steckverbindergehäuse eine Aufnahme zum Einsetzen eines Lüfters hat.

Somit kann ein Lüfter zusammen mit einem als Versorgungsspannungsanschluss ausgebildeten Steckverbinder an einem Gerätegehäuse eines elektronischen Geräts montiert werden. Es sind demnach keine zusätzlichen Halterungen zum Befestigen des Lüfters an dem Gerätegehäuse erforderlich. Der Spannungsversorgungssteckplatz eines Gerätegehäuses kann demnach gleichzeitig zur mechanischen Befestigung des Steckverbindergehäuses und des darin montierbaren Lüfters dienen.

Der Lüfter ist in die Aufnahme eingesetzt und lösbar mit der Aufnahme verbunden. So kann ein kostengünstiger Austausch des Lüfters ermöglicht werden.

Der Steckverbinder ist unabhängig von einem in der Aufnahme montierten Lüfter zur unterbrechungsfreien Spannungsversorgung eines elektronischen Geräts eingerichtet. Demnach können das Einsetzen und/oder das Entnehmen eines Lüfters im laufenden Gerätebetrieb erfolgen, ohne, dass es zu einer Unterbrechung in der Spannungsversorgung des Geräts kommen.

Der Lüfteranschluss ist zur Spannungsversorgung des Lüfters vorgesehen, wobei eine Spannungsversorgung des Lüfters innerhalb des Steckverbindergehäuses von der Versorgungsspannung des elektronischen Geräts abgezweigt ist.

Der Lüfteranschluss kann als Steckverbinder ausgebildet sein, so dass ein zügiges Trennen und Verbinden der Spannungsversorgung des Lüfters ermöglicht wird.

Der Steckverbinder kann eine Diagnoseschaltung haben, die dazu eingerichtet ist, eine Leistungsaufnahme des Lüfters zu überwachen. So kann eine Überlastung und Beschädigung eines vorgeschalteten, den Lüfter und das elektronische Gerät versorgenden Netzteils vermieden werden, falls es am Lüfter z.B. zu einem Kurzschluss kommt. Demnach kann die Diagnoseschaltung insbesondere dazu eingerichtet sein, einen Lüfterbetrieb in dessen vorgesehenen Nennarbeitsbereich zur überwachen.

Der Steckverbinder kann eine Diagnose- und/oder Statusanzeige aufweisen, die durch Lichtzeichen einen Betriebszustand und/oder einen Wartungsbedarf anzeigt, wobei die Diagnose- und/oder Statusanzeige ein oder mehrere LED-Leuchtmittel aufweist, wobei ein oder mehrere LED-Leuchtmittel ein- oder mehrfarbig sind.

Die Diagnoseschaltung kann mit dem elektronischen Gerät verbindbar sein, so dass ein Diagnosesignal der Diagnoseschaltung an das elektronische Gerät weitergegeben wird.

Beispielsweise kann das Diagnosesignal über eine elektromechanische Verbindung an einen Verbraucher des elektronischen Geräts weitergeleitet werden. Alternativ oder ergänzend kann das Diagnosesignal auf eine an einen Verbraucher des elektronischen Geräts abgegebene Betriebsspannung aufmoduliert werden.

Alternativ oder ergänzend kann der Diagnoseschaltung eine Schnittstelle zugeordnet sein, um einen Status des Lüfters drahtlos und/oder kabelgebunden zu übermitteln. Hierzu kann z.B. eine LAN oder W-LAN Schnittstelle verwendet werden. Es versteht sich, dass auch Bluetooth, Infrarot oder andere drahtlose oder kabelgebundene Standards zur Daten- und/oder Signalübermittlung verwendet werden können.

Eine weitere Ausgestaltung des Steckverbinders zeichnet sich dadurch aus, dass der Eingang und der Ausgang zu einem mechanischen Befestigungsmittel, das zum mechanischen Befestigen des Steckverbindergehäuses in dem Spannungsversorgungssteckplatz des Gerätegehäuses des elektronischen Geräts eingerichtet ist, beabstandet sind. So kann in einfacher Weise eine gute Zugänglichkeit des Eingangs und des Ausgangs gewährleistet werden, um Leitungen am Eingang und Ausgang aufzulegen bzw. anzuklemmen.

Das Befestigungsmittel kann eine Rast- oder Schnappverbindung aufweisen, um eine form- und kraftschlüssige Befestigung zu gewährleisten. Die Befestigungsmittel können Formelemente aufweisen, die zum Eingreifen in und/oder Aufnehmen von komplementär geformten Befestigungsmitteln des Gerätegehäuses eingerichtet sind.

Gemäß einem zweiten Aspekt betrifft die Erfindung ein elektronisches Gerät, mit einem Gerätegehäuse, mit einem Verbraucher, der in dem Gerätegehäuse aufgenommen ist, mit einem an dem Gerätegehäuse vorgesehenen Spannungsversorgungssteckplatz zur Aufnahme eines Steckverbinders, wobei ein Steckverbinder in dem Spannungsversorgungssteckplatz aufgenommen ist, um einen Spannungsversorgungsanschluss des elektronischen Geräts bereitzustellen und wobei der Steckverbinder in erfindungsgemäßer Weise ausgebildet ist.

Somit kann ein Lüfter zusammen mit dem als Versorgungsspannungsanschluss ausgebildeten Steckverbinder an dem Gerätegehäuse des elektronischen Geräts montiert werden. Es sind demnach keine zusätzlichen Halterungen zum Befestigen des Lüfters an dem Gerätegehäuse erforderlich. Der Spannungsversorgungssteckplatz des Gerätegehäuses kann demnach gleichzeitig zur mechanischen Befestigung des Steckverbindergehäuses und des darin montierbaren Lüfters dienen.

Es kann vorgesehen sein, dass ein Lüfter in der Aufnahme aufgenommen ist, wobei der Lüfter bündig mit wenigstens einer Seite des Gerätegehäuses abschließt und/oder zumindest abschnittsweise gegenüber einer Seitenwandung des Gerätegehäuses zurückversetzt angeordnet ist. So kann der Lüfter kompakt in das Gerätegehäuse integriert bzw. an dem Gerätegehäuse angeordnet werden.

Eine weitere Ausgestaltung des elektronischen Gerätes zeichnet sich dadurch aus, dass das Gerätegehäuse zur form- und/oder kraftschlüssigen Befestigung an einer Tragschiene eines Schaltschranks eingerichtet ist. So kann das Gerätegehäuse z.B. eine Aufnahme zum Befestigen an einer Hutschiene haben und/oder bewegliche oder starre Klemmelemente bzw. Rastelemente zum Befestigen an einer Hutschiene haben.

Es kann daher vorgesehen sein, dass das elektronische Gerät form- und/oder kraftschlüssig innerhalb eines Schaltschranks montiert bzw. gehalten ist.

Nach einer weiteren Ausgestaltung des elektronischen Geräts ist vorgesehen, dass das Gerätegehäuse wenigstens eine Öffnung zum Luftaustausch zwischen einem Gehäuseinneren und einer Umgebung hat, wobei der Lüfter der Öffnung zugeordnet ist, insbesondere zugewandt ist, um einen Luftvolumenstrom zwischen dem Gehäuseinneren und der Umgebung zu erzeugen.

Im Lüfterbetrieb ist daher insbesondere vorgesehen, dass die Verbraucher innerhalb des Gerätegehäuses mittels eines von dem Lüfter erzeugten Luftstroms gekühlt werden, der das Gehäuseinnere durchströmt.

Der Lüfter kann dazu eingerichtet sein, Luft über die Öffnung in das Gerätegehäuse einzublasen oder aus dem Gerätegehäuse zu saugen.

Das Gerätegehäuse kann zwei oder mehr Öffnungen aufweisen.

Eine Öffnung des Gerätegehäuses kann schlitzförmig sein. Es können eine Mehrzahl schlitzförmiger Geräteöffnungen an dem Gehäuse vorgesehen sein.

Nachfolgend wird die Erfindung anhand einer Ausführungsbeispiele darstellenden Zeichnung näher beschrieben. Es zeigen jeweils schematisch:
- Fig. 1: einen Teilschnitt eines elektronischen Geräts in einer perspektivischen Ansicht von oben;
- Fig. 2: das elektronische Gerät aus Fig. 1 mit einem Steckverbinder und montierten Lüfter;

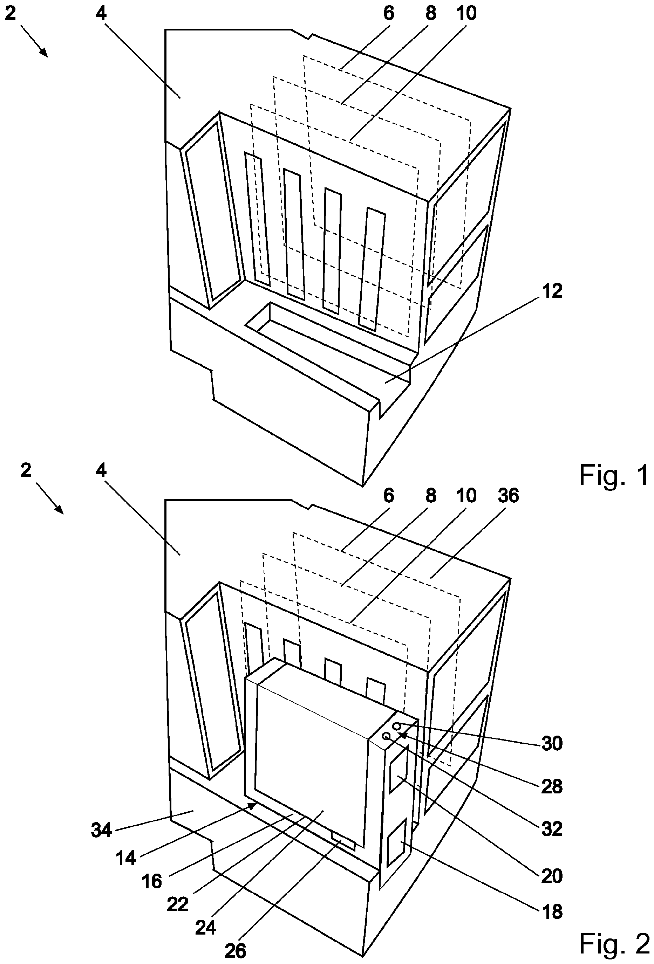

Fig. 1 zeigt einen Teilschnitt eines erfindungsgemäßen elektronischen Geräts 2, dass ein Gerätegehäuse 4 hat, in dem mehrere Verbraucher 6, 8, 10 aufgenommen sind. Das Gerätegehäuse 4 hat einen Spannungsversorgungssteckplatz 12, der zur Aufnahme eines erfindungsgemäßen Steckverbinders eingerichtet ist.

Fig. 2 zeigt das elektronische Gerät 2 aus Fig. 1, wobei ein erfindungsgemäßer Steckverbinder 14 in dem Spannungsversorgungssteckplatz 12 aufgenommen ist. Der Steckverbinder 14 hat ein Steckverbindergehäuse 16. Das Steckverbindergehäuse 16 hat einen Eingang 18 zum Anschluss einer Versorgungsspannung, wobei ein Netzteil an dem Eingang 18 angeschlossen werden kann.

Das Steckverbindergehäuse 16 hat einen Ausgang 20 zum Weiterleiten der Versorgungsspannung an die Verbraucher 6, 8, 10 des elektronischen Gerätes 2. Es versteht sich, dass der Ausgang 20 gemäß alternativer Ausgestaltungen der Erfindung auf einer Unterseite oder Rückseite des Steckverbindergehäuses 16 angeordnet sein kann.

Das Steckverbindergehäuse 16 hat eine Aufnahme 22, in die ein Lüfter 24 eingesetzt ist. Der Lüfter 24 ist vorliegend lösbar in der Aufnahme 22 gehalten.

Der Steckverbinder 14 ist unabhängig von einem in der Aufnahme 22 montierten Lüfter 24 zur unterbrechungsfreien Spannungsversorgung des elektronischen Gerätes 2 bzw. der Verbraucher 6, 8, 10 eingerichtet.

Der Steckverbinder 14 hat einen Lüfteranschluss 26 zur Spannungsversorgung des Lüfters 24, wobei eine Spannungsversorgung des Lüfters 24 innerhalb des Steckverbindergehäuses 16 von der Versorgungsspannung des elektronischen Geräts 2 bzw. der Verbraucher 6, 8, 10 abgezweigt ist.

Der Steckverbinder 14 hat eine Diagnoseschaltung (nicht dargestellt), die dazu eingerichtet ist, eine Leistungsaufnahme des Lüfters 24 zu überwachen.

Weiter hat der Steckverbinder 14 eine Diagnose- und/oder Statusanzeige 28, die durch Lichtzeichen einen Betriebszustand und/oder einen Wartungsbedarf anzeigt, wobei die Diagnoseund/oder Statusanzeige 28 LED-Leuchtmittel 30, 32 aufweist, die mehrfarbig sind.

Die Diagnoseschaltung ist mit dem elektronischen Gerät 2 bzw. einem Verbraucher 6, 8, 10 verbindbar.

Der Lüfter 24 ist gegenüber Seitenwänden 34, 36 des Gerätegehäuses zurückversetzt angeordnet.

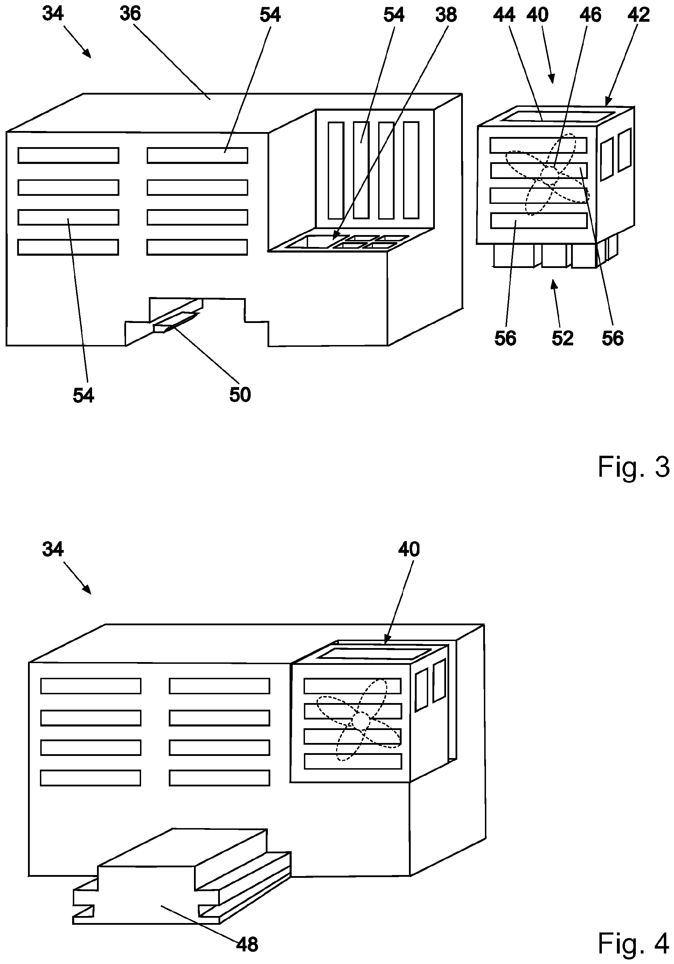

Fig. 3 zeigt eine perspektivische Ansicht eines weiteren erfindungsgemäßen elektronischen Geräts 34, dass ein Gerätegehäuse 36 hat, in dem mehrere Verbraucher aufgenommen sind. Das Gerätegehäuse 34 hat einen Spannungsversorgungssteckplatz 38, der zur Aufnahme eines erfindungsgemäßen Steckverbinders 40 eingerichtet ist.

Fig. 4 zeigt das elektronische Gerät 34 aus Fig. 1, wobei der erfindungsgemäße Steckverbinder 40 in dem Spannungsversorgungssteckplatz 38 aufgenommen ist. Der Steckverbinder 40 hat ein Steckverbindergehäuse 42.

Das Steckverbindergehäuse 42 hat eine Aufnahme 44, in die ein Lüfter 46 eingesetzt ist. Der Lüfter 46 ist vorliegend lösbar in der Aufnahme 44 gehalten.

Der Steckverbinder 40 ist unabhängig von einem in der Aufnahme 44 montierten Lüfter 46 zur unterbrechungsfreien Spannungsversorgung des elektronischen Gerätes 34 bzw. der Verbraucher eingerichtet.

Das Gerätegehäuse 36 ist zur form- und kraftschlüssigen Befestigung an einer Tragschiene 48 eines Schaltschranks eingerichtet (Fig. 4). Hierzu sind Rastelemente 50 vorgesehen.

Das Gerätegehäuse 36 hat Öffnungen 54 zum Luftaustausch zwischen einem Gehäuseinneren und einer Umgebung U. Der Lüfter 46 erzeugt einen Luftvolumenstrom zwischen dem Gehäuseinneren und der Umgebung U. Das Steckverbindergehäuse 42 hat ebenfalls Öffnungen 56 zum Luftaustausch, so dass ein Luftvolumenstrom durch das den Lüfter 46 umgebende Steckverbindergehäuse 42 hin zum Gerätegehäuseinneren oder aus dem Gerätegehäuseinneren gefördert werden kann, um eine Kühlung der Verbraucher zu bewirken.

Der Spannungsversorgungssteckplatz 38 hat sechs Ausnehmungen, die in die Vorsprünge 52 des Steckverbindergehäuses 42 im fertig montierten Zustand eingreifen. Die Vorsprünge 52 können im Bereich der Ausnehmungen mechanisch verrastet sein. Zwischen den Vorsprüngen 52 und dem Gerätegehäuse 36 können im Bereich der Ausnehmungen elektrische Kontaktierungen gebildet sein, um den Verbraucher und/oder den Lüfter mit einer Betriebsspannung zu versorgen.

### Bezugszeichen

- 2, 34: elektronisches Gerät
- 4, 36: Gerätegehäuse
- 6: Verbraucher
- 8: Verbraucher
- 10: Verbraucher
- 12, 38: Spannungsversorgungssteckplatz
- 14, 40: Steckverbinder
- 16, 42: Steckverbindergehäuse
- 18: Eingang
- 20: Ausgang
- 22, 44: Aufnahme
- 24, 46: Lüfter
- 26: Lüfteranschluss
- 28: Diagnose-und/oder Statusanzeige
- 30: LED-Leuchtmittel
- 32: LED-Leuchtmittel
- 48: Tragschiene
- 50: Rastelement
- 52: Vorsprünge
- 54: Öffnung
- 56: Öffnung
- U: Umgebung

## Patentansprüche

1. Steckverbinder,
- mit einem Steckverbindergehäuse (16), das
- einen Eingang (18) zum Anschluss einer Versorgungsspannung und
- einen Ausgang (20) zum Weiterleiten der Versorgungsspannung an einen Verbraucher (6, 8, 10) eines elektronischen Gerätes (2) hat,
- wobei das Steckverbindergehäuse (16) in einen Spannungsversorgungssteckplatz (12) eines Gerätegehäuses (4) des elektronischen Geräts (2) einsteckbar ist, um einen Spannungsversorgungsanschluss des elektronischen Geräts (2) bereitzustellen, und
- wobei das Steckverbindergehäuse (16) eine Aufnahme (22) zum Einsetzen eines Lüfters (24) hat,
- wobei der Steckverbinder (14) unabhängig von einem in der Aufnahme (22) montierten Lüfter (24) zur unterbrechungsfreien Spannungsversorgung des elektronischen Geräts (2) eingerichtet ist,
- wobei ein Lüfteranschluss (26) zur Spannungsversorgung des Lüfters (24) vorgesehen ist,
- wobei eine Spannungsversorgung des Lüfters (24) innerhalb des Steckverbindergehäuses (16) von der Versorgungsspannung des elektronischen Geräts (2) abgezweigt ist,
- wobei das Steckverbindergehäuse (16) Öffnungen (56) zum Luftaustausch umfasst, sodass ein Luftvolumenstrom durch das den Lüfter (24) umgebende Steckverbindergehäuse (16) hin zum Gerätegehäuseinneren oder aus dem Gerätegehäuseinneren gefördert werden kann, um eine Kühlung des Verbrauchers (6, 8, 10) zu bewirken,
**dadurch gekennzeichnet, dass**
der Lüfter (24) in die Aufnahme (22) eingesetzt und lösbar mit der Aufnahme (22) verbunden ist.

2. Steckverbinder nach Anspruch 1,
**dadurch gekennzeichnet, dass**
eine Diagnoseschaltung vorgesehen ist, die dazu eingerichtet ist, eine Leistungsaufnahme des Lüfters (24) zu überwachen.

3. Steckverbinder nach Anspruch 2,
**dadurch gekennzeichnet, dass**
- eine Diagnose- und/oder Statusanzeige (28) vorgesehen ist, die durch Lichtzeichen einen Betriebszustand und/oder einen Wartungsbedarf anzeigt,
- wobei die Diagnose- und/oder Statusanzeige ein oder mehrere LED-Leuchtmittel (30, 32) aufweist,
- wobei ein oder mehrere LED-Leuchtmittel (30, 32) ein- oder mehrfarbig sind.

4. Steckverbinder nach einem der Ansprüche 2 oder 3,
**dadurch gekennzeichnet**, dass-die Diagnoseschaltung mit dem elektronischen Gerät (2) oder einem Verbraucher (6, 8, 10) verbindbar ist
und/oder
- der Diagnoseschaltung eine Schnittstelle zugeordnet ist, um einen Status des Lüfters drahtlos und/oder kabelgebunden zu übermitteln.

5. Steckverbinder nach einem der Ansprüche 1 bis 4,
**dadurch gekennzeichnet, dass**
- der Eingang (18) und der Ausgang (20) zu einem mechanischen Befestigungsmittel, das zum mechanischen Befestigen des Steckverbindergehäuses (16) in dem Spannungsversorgungssteckplatz (12) des Gerätegehäuses (4) des elektronischen Geräts (2) eingerichtet ist, beabstandet sind.

6. Elektronisches Gerät,
- mit einem Gerätegehäuse (4),
- mit einem Verbraucher (6, 8, 10), der in dem Gerätegehäuse (4) aufgenommen ist,
- mit einem an dem Gerätegehäuse (4) vorgesehenen Spannungsversorgungssteckplatz (12) zur Aufnahme eines Steckverbinders (14),
- wobei ein Steckverbinder (14) in dem Spannungsversorgungssteckplatz (12) aufgenommen ist, um einen Spannungsversorgungsanschluss des elektronischen Geräts (2) bereitzustellen und
- wobei der Steckverbinder (14) nach einem der voranstehenden Ansprüche 1 bis 5 ausgebildet ist.

7. Elektronisches Gerät nach Anspruch 6,
**dadurch gekennzeichnet, dass**
- ein Lüfter (24) in der Aufnahme (22) aufgenommen ist, wobei der Lüfter (24) bündig mit wenigstens einer Seitenwandung des Gerätegehäuses (4) abschließt
und/oder
- zumindest abschnittsweise gegenüber einer Seitenwandung (34, 36) des Gerätegehäuses zurückversetzt angeordnet ist.

8. Elektronisches Gerät nach Anspruch 6 oder 7,
**dadurch gekennzeichnet, dass**
- das Gerätegehäuse (4) zur form- und/oder kraftschlüssigen Befestigung an einer Tragschiene eines Schaltschranks eingerichtet ist.

9. Elektronisches Gerät nach einem der Ansprüche 6 bis 8,
**dadurch gekennzeichnet, dass**
- das Gerätegehäuse wenigstens eine Öffnung zum Luftaustausch zwischen einem Gehäuseinneren und einer Umgebung hat,
- wobei der Lüfter der Öffnung zugeordnet ist, um einen Luftvolumenstroms zwischen dem Gehäuseinneren und der Umgebung zu erzeugen.

## Claims

1. Plug connector,
- having a plug connector housing (16) which has
- an input (18) for connecting a supply voltage, and
- an output (20) for forwarding the supply voltage to a consumer (6, 8, 10) of an electronic device (2),
- wherein the plug connector housing (16) can be plugged into a voltage supply plug-in location (12) of a device housing (4) of the electronic device (2) in order to provide a voltage supply connection of the electronic device (2), and
- wherein the plug connector housing (16) has a seat (22) for inserting a blower (24),
- wherein independently from a blower (24) installed in the seat (22), the plug connector (14) is designed for an interruption-free voltage supply of the electronic device (2),
- wherein a blower connection (26) is provided for the voltage supply of the blower (24),
- wherein a voltage supply of the blower (24) is diverted within the plug connector housing (16) from the supply voltage of the electronic device (2),
- wherein the plug connector housing (16) has openings (56) for an air exchange, so that an air volume flow through the plug connector housing (16), which surrounds the blower (24), can be conveyed toward the device housing interior or from the device housing interior in order to effect a cooling of the consumers (6, 8, 10),
**characterized in that**
a blower (24) is inserted in the seat (22) and detachably connected to the seat (22).

2. Plug connector according to claim 1,
**characterized in that**
a diagnostic circuit is provided which is designed to monitor a power consumption of the blower (24).

3. Plug connector according to claim 2,
**characterized in that**
- a diagnosis and/or status display (28) is provided which indicates an operating state and/or a need for maintenance using light signals,
- wherein the diagnosis and/or status display has one or more LED light sources (30, 32),
- wherein one or more LED light sources (30, 32) are singleor multicolored.

4. Plug connector according to one of claims 2 or 3,
**characterized in that**
- the diagnostic circuit is connectable to the electronic device (2) or a consumer (6, 8, 10)
and/or
- an interface is associated with the diagnostic circuit in order to transmit a status of the blower in a wireless and/or wired manner.

5. Plug connector according to one of claims 1 to 4,
**characterized in that**
- the input (18) and the output (20) are spaced apart from a mechanical fastener designed for mechanically fastening the plug connector housing (16) in the voltage supply plug-in location (12) of the device housing (4) of the electronic device (2).

6. Electronic device,
- having a device housing (4),
- with a consumer (6, 8, 10) which is accommodated in the device housing (4),
- with a voltage supply plug-in location (12) provided on the device housing (4) for receiving a plug connector (14),
- wherein a plug connector (14) is accommodated in the voltage supply plug-in location (12) in order to provide a voltage supply connection of the electronic device (2), and
- wherein the plug connector (14) is designed according to one of the previous claims 1 to 5.

7. Electronic device according to claim 6,
**characterized in that**
- a blower (24) is accommodated in the seat (22), wherein the blower (24) is flush with at least one sidewall of the device housing (4)
and/or
- is arranged at least in sections to be set back with regard to a sidewall (34, 36) of the device housing.

8. Electronic device according to one of claims 6 or 7,
**characterized in that**
- the device housing (4) is designed for an interlocking and force-locking fastening on a support rail of a switchgear cabinet.

9. Electronic device according to one of claims 6 to 8,
**characterized in that**
- the device housing has at least one opening for an air exchange between a housing interior and an environment,
- wherein the blower is associated with the opening in order to generate an air volume flow between the housing interior and the environment.

## Revendications

1. Connecteur,
- avec un boîtier de connecteur (16) ayant
- une entrée (18) pour connecter une tension d'alimentation et
- une sortie (20) pour transmettre la tension d'alimentation à un consommateur (6, 8, 10) d'un appareil électronique (2),
- dans lequel le boîtier de connecteur (16) peut être inséré dans un emplacement d'alimentation en tension (12) d'un boîtier d'appareil (4) de l'appareil électronique (2) pour fournir une connexion d'alimentation en tension de l'appareil électronique (2), et
- dans lequel le boîtier de connecteur (16) comporte un logement (22) pour l'insertion d'un ventilateur (24),
- dans lequel le connecteur (14) est indépendant d'un ventilateur (24) monté dans le logement (22) pour alimenter en tension sans interruption l'appareil électronique (2),
- dans lequel un raccord de ventilateur (26) est prévu pour l'alimentation en tension du ventilateur (24),
- dans lequel une alimentation en tension du ventilateur (24) à l'intérieur du boîtier de connecteur (16) est dérivée de la tension d'alimentation de l'appareil électronique (2),
- dans lequel le boîtier de connecteur (16) comprend des ouvertures (56) pour l'échange d'air, de sorte qu'un débit volumétrique d'air à travers le boîtier de connecteur (16) entourant le ventilateur (24) vers l'intérieur du boîtier de l'appareil ou de l'intérieur du boîtier de l'appareil peut être requis pour provoquer un refroidissement du consommateur (6, 8, 10),
**caractérisé en ce que**
le ventilateur (24) est inséré dans le logement (22) et relié de manière amovible au logement (22).

2. Connecteur selon la revendication 1,
**caractérisé en ce que**
un circuit de diagnostic est prévu, qui est configuré pour surveiller une consommation d'énergie du ventilateur (24).

3. Connecteur selon la revendication 2,
**caractérisé en ce que**
- un indicateur de diagnostic et/ou d'état (28) est prévu, qui indique par des signaux lumineux un état de fonctionnement et/ou un besoin d'entretien,
- dans lequel l'indicateur de diagnostic et/ou d'état comporte une ou plusieurs ampoules LED (30, 32),
- dans lequel une ou plusieurs ampoules LED (30, 32) sont monochromes ou multicolores.

4. Connecteur selon l'une des revendications 2 à 3,
caractérisé en ce que- le circuit de diagnostic est connectable à l'appareil électronique (2) ou à un consommateur (6, 8, 10)
et/ou
une interface est associée au circuit de diagnostic pour transmettre un état du ventilateur sans fil et/ou filaire.

5. Connecteur selon l'une des revendications 1 à 4,
**caractérisé en ce que**
- l'entrée (18) et la sortie (20) sont espacées d'un moyen de fixation mécanique agencé pour fixer mécaniquement le boîtier de connecteur (16) dans le logement d'alimentation en tension (12) du boîtier d'appareil (4) de l'appareil électronique (2).

6. Appareil électronique,
- avec un boîtier d'appareil (4),
- avec un consommateur (6, 8, 10) logé dans le boîtier de l'appareil (4),
- avec un logement d'alimentation en tension (12) prévu sur le boîtier de l'appareil (4) pour recevoir un connecteur (14),
- dans lequel un connecteur (14) est logé dans le logement d'alimentation en tension (12) pour fournir une connexion d'alimentation en tension de l'appareil électronique (2) et
- dans lequel le connecteur (14) est conçu selon l'une des revendications précédentes 1 à 5.

7. Appareil électronique selon la revendication 6,
**caractérisé en ce que**
- un ventilateur (24) est logé dans le logement (22), le ventilateur (24) affleurant au moins une paroi latérale du boîtier de l'appareil (4)
et/ou
- au moins partiellement en retrait par rapport à une paroi latérale (34, 36) du boîtier de l'appareil.

8. Appareil électronique selon la revendication 6 ou 7,
**caractérisé en ce que**
- le boîtier de l'appareil (4) est configuré pour une fixation par liaison de forme et/ou par liaison de force sur un rail de support d'une armoire électrique.

9. Appareil électronique selon l'une des revendications 6 à 8, **caractérisé en ce que**
- le boîtier de l'appareil a au moins une ouverture pour l'échange d'air entre un intérieur du boîtier et un environnement,
- dans lequel le ventilateur est associé à l'ouverture pour créer un flux d'air entre l'intérieur du boîtier et l'environnement.
